# EUROPEAN PATENT SPECIFICATION

(11) **EP 0 620 674 B1**
(45) Date of publication and mention of the grant of the patent: **24.07.1996**
(21) Application number: 93201115.8
(22) Date of filing: 16.04.1993
(51) Int. Cl.: H04N 1/40, G03F 7/07

(54) **Method for making a lithographic printing plate**
Verfahren zur Herstellung lithographischer Druckformen
Procédé de fabrication de plaques d'impression lithographiques

(43) Date of publication of application: 19.10.1994
(73) Proprietor: AGFA-GEVAERT naamloze vennootschap, B-2640 Mortsel (BE)
(72) Inventor: Delabastita, Paul, c/o Agfa-Gevaert N.V., DIE 3800, B-2640 Mortsel (BE); Van Hunsel, Johan, c/o Agfa-Gevaert N.V., DIE 3800, B-2640 Mortsel (BE); Schelfaut, Frank, c/o Agfa-Gevaert N.V., DIE 3800, B-2640 Mortsel (BE)

(56) References cited:
- EP-A- 0 423 399
- EP-A- 0 571 010
- DE-A- 2 512 038
- US-A- 4 501 811
- US-A- 4 784 933
- IEEE TRANSACTIONS ON COMMUNICATIONS, vol. COM29, no. 12, December 1981, NEW YORK (US), pages 1898-1925; J.C. STOFFEL et al.: 'A Survey of Electronic Techniques for Pictorial Image Reproduction'
- PROCEEDINGS OF THE SOCIETY FOR INFORMATION DISPLAY, vol. 27, no. 4, 1986, New York (US), pages 305-308; G.S. FAWCETT et al.: 'Halftoning techniques using error correction'
- COMPUTER GRAPHICS, vol. 25, no. 4, July 1991, pagrs 81-90; L. VELHO et al.: 'Digital Halftoning with Space Filling Curves'

## Description

### 1. Field of the invention.

The present invention relates to a method for making a lithographic printing plate, in particular to a method wherein a lithographic printing plate precursor is scan-wise exposed.

### 2. Background of the invention.

Lithographic printing is the process of printing from specially prepared surfaces, some areas of which are capable of accepting ink (oleophilic areas) whereas other areas will not accept ink (oleophobic areas). The oleophilic areas form the printing areas while the oleophobic areas form the background areas.

Two basic types of lithographic printing plates are known. According to a first type, so called wet printing plates, both water or an aqueous dampening liquid and ink are applied to the plate surface that contains hydrophilic and hydrophobic areas. The hydrophilic areas will be soaked with water or the dampening liquid and are thereby rendered oleophobic while the hydrophobic areas will accept the ink. A second type of lithographic printing plates operates without the use of a dampening liquid and are called driographic printing plates. This type of printing plates comprise highly ink repellant areas and oleophilic areas. Generally the highly ink repellant areas are formed by a silicon layer.

Lithographic printing plates can be prepared using a photosensitive lithographic printing plate precursor, also called imaging element. Such imaging element is exposed in accordance with the image data and is generally developed thereafter so that a differentiation results in ink accepting properties between the exposed and unexposed areas.

Examples of photosensitive lithographic printing plate precursors are for example the silver salt diffusion transfer (hereinafter DTR) materials disclosed in EP-A-410500, EP-A-483415, EP-A-423399, imaging elements having a photosensitive layer containing diazonium salts or a diazo resin as described in e.g. EP-A-450199, imaging elements having a photosensitive layer containing a photopolymerizable composition as described in e.g. EP-A-502562, EP-A-491457, EP-A-503602, EP-A-471483 or DE-A-4102173.

Alternatively a lithographic printing plate may be prepared from a heat mode recording material as a lithographic printing plate precursor. Upon application of a heat pattern in accordance with image data and optional development the surface of such heat mode recording material may be differentiated in ink accepting and ink repellant areas. The heat pattern may be caused by a direct heating source such as a thermal head but may also be caused by a light source as e.g. a laser. In the latter case the heat mode recording material will include a substance capable of converting the light into heat. Heat mode recording materials that can be used for making a lithographic printing plate precursor are described in e.g. EP-A-92201633, DE-A-2512038, FR-A-1.473.751, Research Disclosure 19201 of april 1980 or Research Disclosure 33303 of januari 1992.

From the above it will be clear that lithographic printing is only capable of reproducing two tone values because the areas will acceptant ink or not. Thus lithographic printing is a so called binary process. In order to reproduce originals having contiuously changing tone values by such process halftone screening techniques are applied.

EP-A-0 571 010, which constitutes prior art within the meaning of Art. 54(3) EPC, discloses frequency modulation screening in combination with a digital film recorder, consisting of a scanning laser beam exposing a photosensitive material, which can be a photographic film from which later on a printing plate is prepared by means of photomechanical techniques.

In COMPUTER GRAPHICS, vol. 25, no. 4, July 1991, pages 81-90, L. VELHO et al. "Digital Halftoning with Space Filling Curves" a new digital halftoning technique is disclosed, that uses space filling curves to generate aperiodic patterns of clustered dots, to reproduce continuous-tone picture on a specific graphic display device. The work presented in the paper addresses problems associated with laser printers, based on electrophotographic technology. The technique is primarily intended for medium to high resolution bi-level devices that cannot accommodate isolated black or white pixels. A 300 dpi laser printer is used as the graphics output device.

In a commonly used halftone screening technique, the continuously changing tone values of the original are modulated with periodically changing tone values of a superimposed two-dimensional screen. The modulated tone values are then subject to a thresholding process wherein tone values above the treshold value will be reproduced and those below will not be reproduced. The process of tone-value modulation and thresholding results in a two-dimensional arrangement of equally spaced "screen dots" whose dimensions are proportional to the tone value of the original at that particular location. The number of screen dots per unit distance determines the screen frequency or screen ruling. This screening technique wherein the screen frequency is constant and inversely proportional to the halftone cell size and, hence, to the maximum density of the screen dot, is referred to as amplitude-modulation screening or autotypical screening. This technique can be implemented photo-mechanically or electronically.

The photo-mechanical implementation involves an analog process wherein a screen of equally spaced dots is physically superimposed, in contact or in projection with the original. Screen dots are formed when this combination is photographically reproduced in a system wherein thresholding is achieved through the use of special photographic films and developing chemicals producing a very high photographic contrast resulting a sharp distinction between tone values above and below a certain level.

The electronic implementation of autotypical screening is a digital process wherein the continuous tone values of the original are broken up into discrete tone-value levels, specified at discrete areal coordinates within the original image. Each tone value is compared with an electronic threshold level, and values above the threshold are reproduced while those below the threshold are not. Screen dots are formed when a specific pattern of threshold values is defined in a two-dimensional array corresponding to the size of a halftone cell, and this threshold pattern is periodically applied accross the image.

It will further be clear that in order to reproduce a color image using lithographic printing it will be required to separate the image in three or more part-images corresponding to primary colors that when printed over each other yield the desired color at any place within the image. Each of these color separation has to be screened as described above.

It is well known that the above described procedure of screening and color separation results in certain artifacts on a copy obtained in lithographic printing. Such artifacts are e.g. enlarging of the screen dots on the press, Moiré patterns, color shifts etc.. Due to the complex and critical nature of lithographic printing of continuous tone originals and in particular color original the need exists for a preview of the final result.

Of course, in order to make such preview one could make a proof print under the same conditions as those intended for the final printing. However such would be very time consuming and expensive. Thus proof printing materials have been developed to simulate the final print including artifacts that are expected to occur in the final print.

Such proofing materials are designed to be used in conjunction with the photographic films also used to make the final printing plates. As a consequence they are only suitable for the proofing of printing plates that are obtained by camera-exposure or contact exposures of imaging elements.

The above proofing materials are generally not suitable for proofing the printing results of plates that are obtained by scan exposure of an imaging element under the control of a computer. Such procedure is called computer-to-plate and obviates the need for photographic films since the image data being in a digital form is used to directly expose the imaging element. The exposure is carried out by an output device such as e.g. a laser, LED or Cathode Ray Tube, that scans over the imaging element and exposes it according to the digital image data.

Thus for the latter type of printing plates special Direct Digital Proofing (DDP) techniques were developed to generate a printing proof. However because several types of artifacts have to be simulated it can be understood that DDP-techniques include a high degree of sophistication and as a result are expensive.

### 3. Summary of invention.

It is an object of the present invention to provide a method for making a lithographic printing plate by means of scan-exposure of a lithographic printing plate precursor and wherein the printing results can be previewed in a less expensive and convenient way.

Further objects of the present invention will become clear from the description hereinafter.

According to the present invention there is provided a method for making a lithographic printing plate from an original containing continuous tones comprising the steps of:
- screening said original to obtain screened data
- scan-wise exposing a lithographic printing plate precursor according to said screened data, said lithographic printing plate precursor having a surface capable of being differentiated in ink accepting and ink repellant areas upon said scan-wise exposure and an optional development step and
- optionally developing a thus obtained scan-wise exposed lithographic printing plate precursor,
   characterized in that said screening is a frequency modulation screening.

### 4. Brief description of the drawings.

The present invention is illustrated by way of example and without the intention to limit the invention thereto with the following drawings:

Figure 1 shows a Hilbert curve before (a) and after randomization (b).

Figure 2 shows the order of processing image pixels when the image is recursively subdivided into matrices.

Figure 3 shows a schematic representation of a circuit for implementing a halftoning method according to the invention.

### 5. Detailed description of the invention.

Frequency modulation screening is a technique in which the continuously changing tone values of an original are reproduced by means of equally sized micro dots, the number of which is proportional to the tone value of the original image. The name frequency modulation refers to the fact that the number of micro dots per unit surface (the frequency) fluctuates in proportion to the tone value in that same area.

As a consequence of the use of frequency modulation screening for exposing a lithographic printing plate precursor the printing results obtained from such a plate could well be simulated by less expensive, less complex and even relatively low resolution systems (in comparison with lithographic printing). Examples of such systems that can be used for generating a printing proof are ink-jet printers, Xerographic printers and thermal wax printers. It is even possible to use a printing device such as a thermal sublimation printing device that in itself does not require screening to yield a continuous tone image.

A suitable frequency modulation screening technique for use in connection with the present invention is the well-known Error diffusion first described by Floyd and Steinberg "An adaptive algorithm for spatial grey scale" SID 75 Digest. Society for information display 1975, pp. 36-37. According to the error diffusion technique the image pixels of a continuous tone image are processed one after the other according to a predetermined path e.g. from left to right and top to bottom.

The tone value of each image pixel is thereby compared with a threshold value which is generally the tone value half-way the tone scale e.g. 128 when the tones of the image-pixels range from 0 to 256. Depending on whether the tone value of the image pixel is above or below the threshold value a halftone dot will be set or not in the corresponding reproduction of the image pixel. The resulting error or weighted error, i.e. the difference between the reproduction value and actual value of the image pixel, is then added to the tone value of one or more neighbouring image pixels that are still unprocessed. Details about the error diffusion screening method may be found in the aforementioned reference or in US-P-5.175.804.

A more preferred variant of frequency modulation screening for use in connection with the present invention is a method similar to the error diffusion with the exception that the order in which the image pixels are processed can be described by a space filling deterministic fractal curve or a randomized space filling curve.

This type of frequency modulation screening comprises the following steps:
- selecting an unprocessed image pixel according to a space filling deterministic fractal curve or a randomized space filling curve and processing said unprocessed image pixel as follows:
- determining from the tone value of said unprocessed image pixel a reproduction value to be used for recording said image pixel on a lithographic printing plate precursor,
- calculating an error value on the basis of the difference between said tone value of said unprocessed image pixel and said reproduction value, said unprocessed image pixel thereby becoming a processed image pixel,
- adding said error value to the tone value of an unprocessed image pixel and replacing said tone value with the resulting sum or alternatively distributing said error value over two or more unprocessed image pixels by replacing the tone value of each of said unprocessed image pixels to which said error value will be distributed by the sum of the tone value of the unprocessed image pixel and part of said error,
- repeating the above steps until all image pixels are processed.

A suitable deterministic fractal curve is for example the so called "Hilbert Curve" disclosed by Witten Ian H., and Radford M. Neal, "Using Peano Curves for Bilevel Display of Continuous-Tone Images", IEEE CG&A, May 1982, pp. 47-52.

According to the most preferred embodiment of the present invention the order of processing the image pixels is ruled by a randomized space filling curve. With the term "randomized space filling curve" is meant that the processing of the image pixels follows basically a pre-determined curve that assures that each image pixel will be processed but which curve is randomized at a number of points so that patterns are avoided.

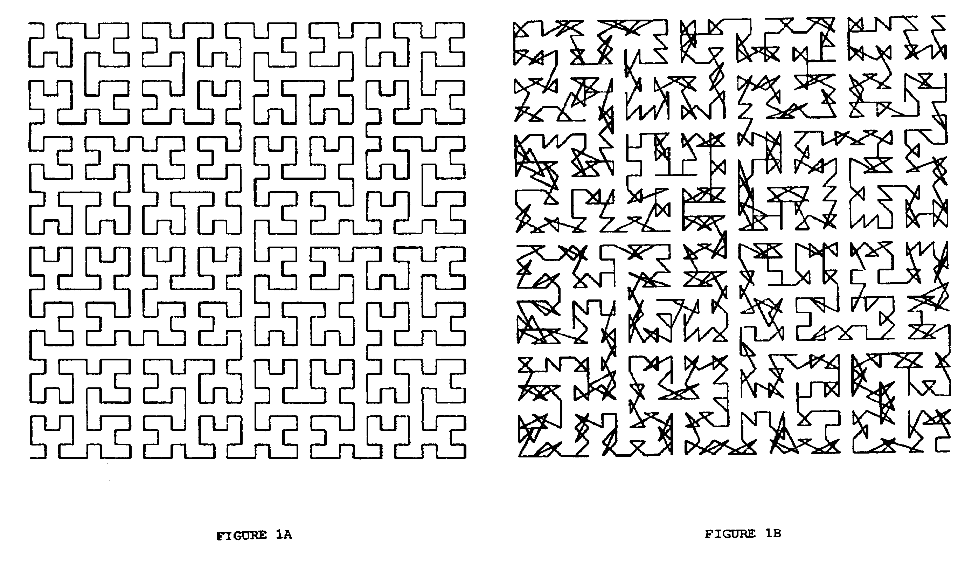

Such randomized space filling curve can be obtained in different ways. For example the Hilbert Curve may be used as the pre-determined curve on which randomization is performed. A computer program that can be used to obtain a randomized Hilbert Curve is shown in annex 1. Figure 1 gives a visualization of a Hilbert Curve before and after randomization. The randomization of the Hilbert Curve may be carried out by following the curve and at every point of the curve deciding at random whether or not the curve will be permutated at the particular point.

According to an alternative a randomized space filling curve may be obtained by dividing the image into matrices of image pixels. Within each of these matrices the image pixels are processed at random until all image pixels are processed. The order in which the matrices are processed may then be selected at random or in a predetermined way.

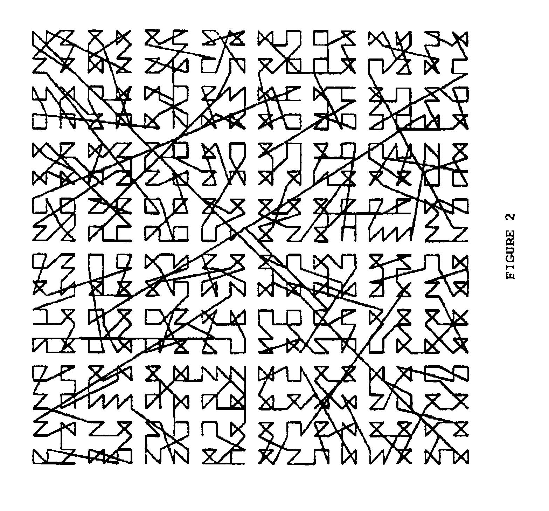

An alternative to the above method of dividing the image into matrices is the recursively division of the image into smaller matrices until the size of a matrix reaches an image pixel. At every subdivision into smaller submatrices a random ordering of processing the matrices is assigned to every submatrix. Annex 2 shows a computer program that can be used to carry out this process and figure 2 shows the resulting order in which image pixels are processed in this case. It will be clear that this method works well for square image but imposes problems for other images. To overcome this problem the original image may be padded with zeors along its longest side until a square is obtained. In a second approach, a path may be calculated with the size of the longest rectangular image. The points of the path that do not belong to the image may then be skipped during processing.

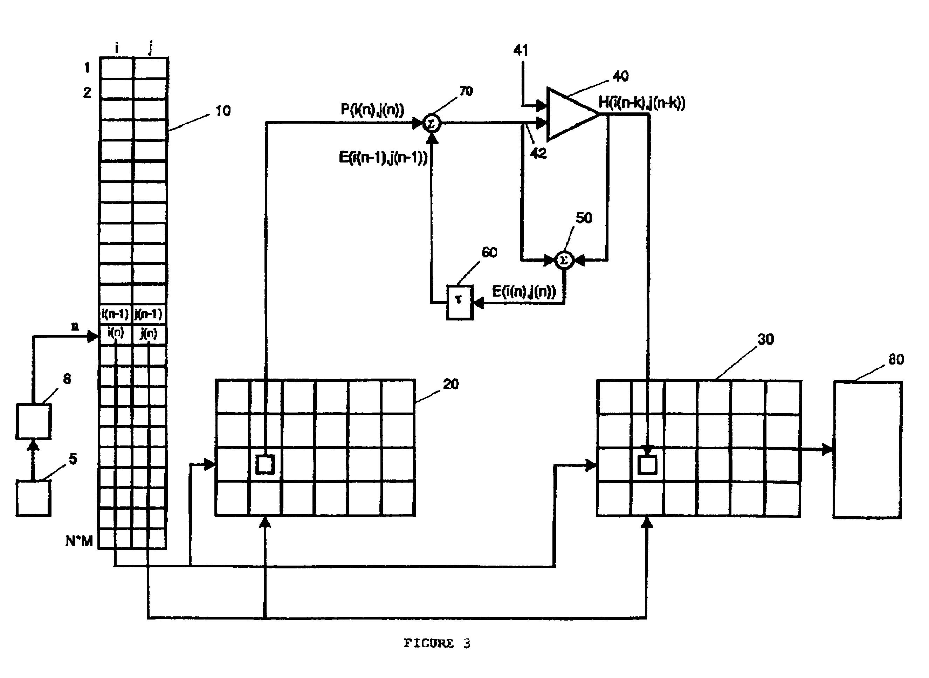

Figure 3 shows a circuit to perform a frequency modulation screening in combination with a binary recording device, e.g. an image-setter. First the different building blocks of this circuit are described, later on its operation will be explained.

Block (20) is a memory block containing the contone pixel values of an image. Typically these are 8 bit values, organized as N lines with M columns. Block (30) is a memory block with the same lay out as block (20), in which the the halftoned pixel values will be stored. In the case of a binary recording device, every halftoned pixel word has a length of 1 bit. Block (80) is a device capable of scan-wise exposing a substrate i.e. a lithographic printing plate precursor using the information in block (30). Block (70) is an arithmetic unit capable of calculating the sum of the pixelvalue P (i,j) and the error E at the output of a delay register (60). The conversion of a contone pixel value into a halftoned pixel value takes place in block (40). This conversion may be based on a thresholding operation: if the contone value at point (i,j) is below the value of 128, a value "0" is stored in the halftone memory, otherwise a "1" is stored. Block (50) contains an arithmetic unit that is capable to calculate the error between the original contone value, and the halftoned pixel value, and to store it in the delay register (60). Block (8) is a counter that sequences the processing of the N*M pixels of the image. Block (10) is LUT with N*M entries (one for every image pixel), and a UNIQUE combination of a row and column address that corresponds with one pixel position in the image. Block (5) is a clock.

The table of block (10) thus holds the order in which the image pixels will be processed. This table may be calculated according to one of the methods described above.

The operation of the diagram is now explained. At every clock pulse, the counter (8) is incremented, and a new pair of coordinates (i(n),j(n)) is obtained from block (10). These coordinates are used as address values to the pixel memory (20), to obtain a contone pixel value P(i(n),j(n)). This pixel value is immediately added to the error E(i(n-1),j(n-1)), that was stored in register (60) after the previous halftone step, and the sum of both is compared to the threshold value (41) in block (40). The outcome of the thresholding operation determines the value H(i(n),j(n)) that will be written into the halftone pixel memory at position (i(n),j(n)). At the same time a new error E(i(n),j(n)) is calculated from the difference between P(i(n),j(n)) and H(i(n),j(n)), and stored in the delay register (60). The circuit is initialized by setting the counter (8) to 1, the error to 128, and the operation is terminated when the counter reaches the level N*M. After that, the halftone memory (30) is read out line by line, column by column, and its contents are recorded on a lithographic printing plate precursor by the recorder (80).

According to a variant of the above circuit the error that is obtained from the difference between the contone pixel and the halftoned pixel value, may, instead of being diffused only to the next pixel in the order of processing, diffused to more than one of the unprocessed pixels. Instead of using the error of one pixel, one may also use an average error of a number of pixels.

In case of a color image, the above described screening process is performed on each of the color separations of the image. Preferably the color image is separated in its Yellow, Magenta, Cyan and Black (CMYK) components. Each of these components may then be screened according to the present invention and used to scan-wise expose four lithographic printing plate precursors. Four lithographic printing plates, one for each color separation, will thus be obtained. The color separations can then be printed over each other in register in a lithographic printing machine using the four plates.

According to a preferred embodiment of the present invention the CMYK color separations are prepared starting from a device independent representation of the color image. In a device independent color representation each color of an image is uniquely defined by device independent color coordinates within the color spectrum. Such device independent color coordinates are e.g. CIEXYZ or CIEL*a*b*.

From this device independent color coordinates may then be calculated the CMYK separations which are device dependent color signals for controlling a color reproduction device. This conversion is performed in such a way that the reproduction of a color will match the target color as close as possible.

To obtain a device independent color representation of an image a conversion of the device dependent color information obtained from an input device such as a color scanner a similar conversion but in the opposite direction will be necessary.

A method for performing these conversions is disclosed in EP-A-92115339.1. Such method uses conversion tables specific for each particular input or output device to convert the device dependent color image signals into device independent color signals and vice versa.

The method of the present invention can be used with lithographic printing plate precursors having a surface that can be differentiated upon image-wise exposure and an optional development step. Examples of printing plate precursors that can be used in connection with the present invention are printing plate precursors having a photosensitive layer or a heat mode recording layer.

A particular suitable printing plate precursor or imaging element is a so called mono-sheet DTR material. Two variants of such mono-sheet DTR material for making a lithographic printing plate are known and can be used.

A first type of mono-sheet DTR material comprises on a support in the order given a silver halide emulsion layer and an image receiving layer containing physical development nuclei e.g. a heavy metal sulphide as e.g. PdS. The image receiving layer is preferably free of binder or contains a hydrophilic binder in amount of not more than 30% by weight. Subsequent to image-wise exposure the mono-sheet DTR material is developed using an alkaline processing liquid in the presence of developing agents e.g. of the hydroquinone type and/or pyrazolidone type and a silver halide solvent such as e.g. a thiocyanate. Subsequently the plate surface is neutralized with a neutralizing liquid. Details about the consitution of this type of mono-sheet DTR material and suitable processing liquids can be found in e.g. EP-A-423399, US-P-4.501.811 and US-P-4.784.933. Lithographic printing plate precursors of this type are marketed by Agfa-Gevaert NV under the name SETPRINT.

These type of printing plate precursors can be exposed using a laser or LED containing device. Examples of HeNe laser containing exposure units are the image-setters LINOTRONIC 300, marketed by LINOTYPE-HELL Co, and Select 5000/7000, marketed by Miles Inc.. An image-setter provided with an Ar ion laser that can be used is LS 210, marketed by Dr-Ing RUDOLF HELL GmbH. Exposure units provided with a laserdiode that can be used are LINOTRONIC 200, marketed by LINOTYPE-HELL Co, and ACCUSET marketed by Miles Inc..

The second type of mono-sheet DTR material also suitable for use in connection with the present invention comprises on an roughened and anodized aluminium support in the order given an image receiving layer as described above, a hydrophilic layer and a silver halide emulsion layer. Subsequent to image-wise exposure the mono-sheet DTR material is developed using an alkaline processing liquid in the presence of developing agents e.g. of the hydroquinone type and/or pyrazolidone type and a silver halide solvent such as e.g. a thiocyanate. Thereafter the plate is rinsed with water, preferably warm water, to remove the silver halide emulsion layer and hydrophilic layer. The obtained silver image in the image receiving may further be treated with a hydrophobizing liquid containing hydrophobizing agents to improve the ink accepting properties of the silver image. Details about the constitution, processing liquid and method for developing the mono-sheet DTR material may be found in EP-A-410500 and EP-A-483415. Because of the stifness of the aluminium support this type of imaging element is preferably exposed using a flat-bed scanner.

An other type of imaging element suitable for use in connection with the present invention is one comprising on a support having a hydrophilic surface or being coated with a hydrophilic layer a photosensitive layer containing a diazo resin, diazonium salt or a photopolymerizable composition. Such type of printing plate precursors are disclosed in EP-A-450199, EP-A-502562, EP-A-487343, EP-A-491457, EP-A-503602, EP-A-471483, DE-A-4102173, Japanese patent application laid open to public inspection number 244050/90 etc.. Subsequent to the exposure these printing plate precursors are developed using plain water, a developing liquid being generally a mixture of water and one or more organic solvents or some of them may be developed using a delamination foil.

An imaging element suitable for use in connection with the present invention and that can be used to yield driographic printing plates is disclosed in e.g. EP-A-475384, EP-A-482653, EP-A-484917 etc..

It is also possible to use imaging elements having a heat mode recording layer. Such heat mode recording layer is a layer containing a substance that is capable of converting light into heat. Examples of heat mode recording layers are e.g. vacuum or vapour deposited Bismuth or Aluminium layers, layers containing infra-red dyes or pigments, layers containing carbon black etc.. Suitable heat mode recording materials for use in connection with the present invention are described in e.g. EP-A-92201633, DE-A-2512038, FR-A-1.473.751, Research Disclosure 19201 of april 1980 or Research Disclosure 33303 of januari 1992.

The latter two heat mode recording materials do not require a developing step or can be developed by simply cleaning the heat mode recording material with e.g. a dry cotton pad.

Suitable devices for scan-wise exposure of a lithographic printing plate precursor are e.g. Cathode Ray Tubes, LED's or lasers. Most preferably used devices are lasers, the particular type of laser and power being dependent on the type of printing plate precursor. Generally a lithographic printing plate precursor based on a silver halide photosensitive layer will require less powerful lasers while heat mode recording materials will generally require powerful lasers.

Examples of lasers that can be used in connection with the present invention are e.g. He/Ne lasers, Argon ion lasers, semiconductor lasers, YAG lasers e.g. Nd-YAG lasers etc..

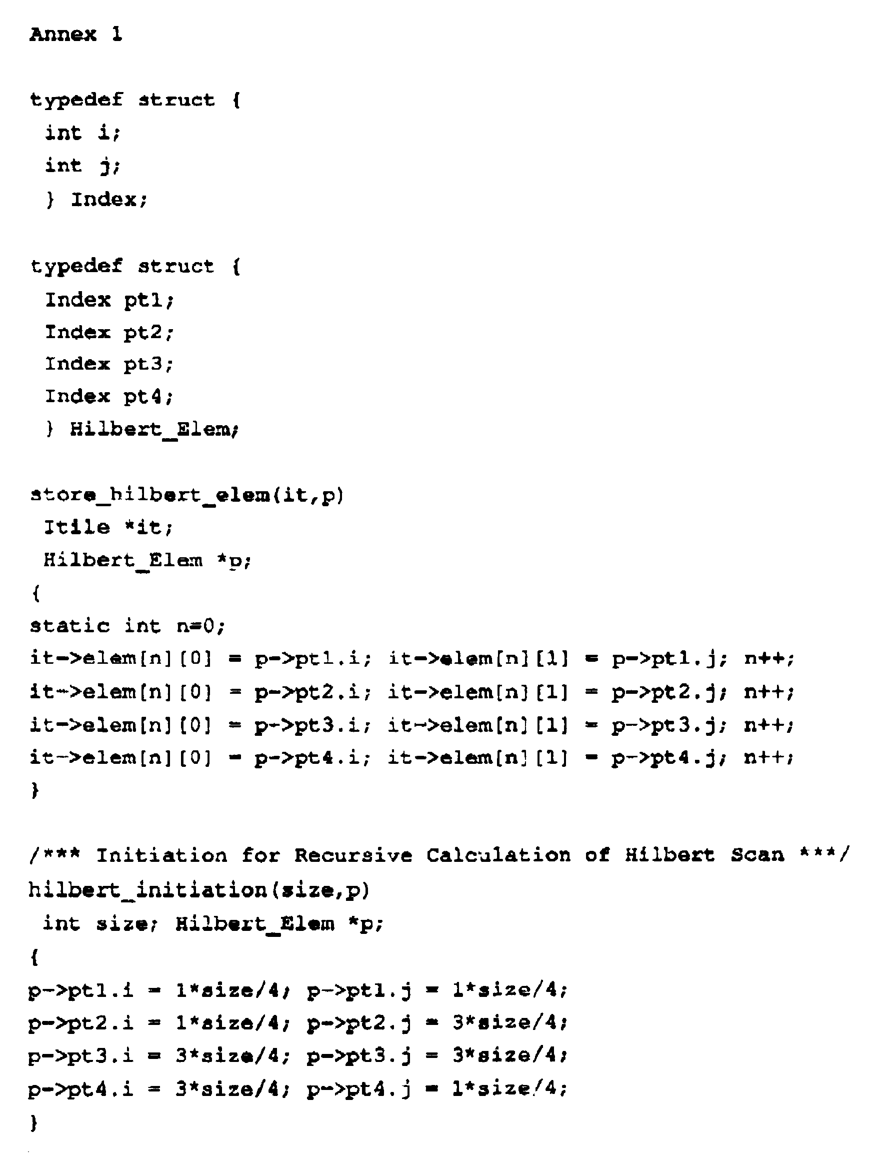

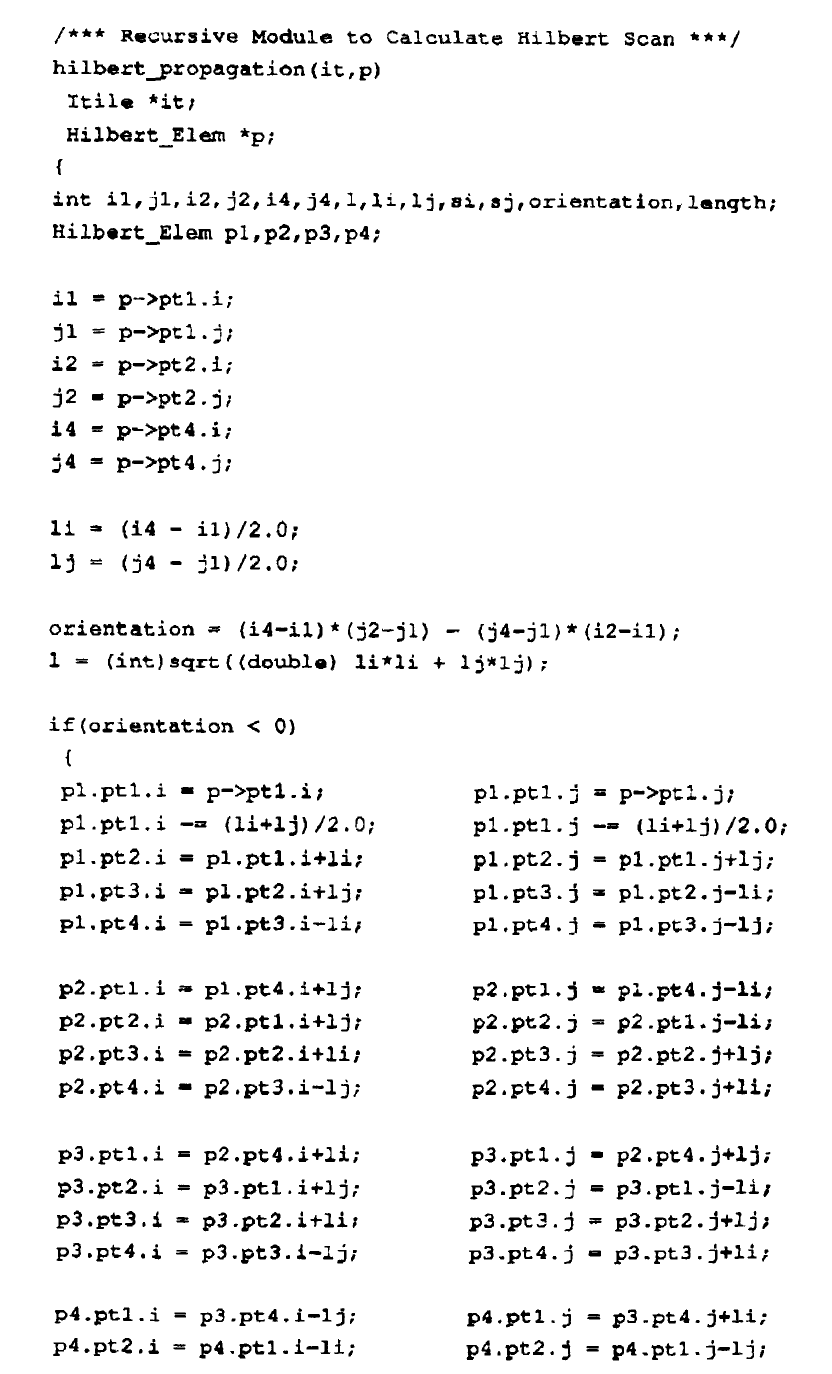

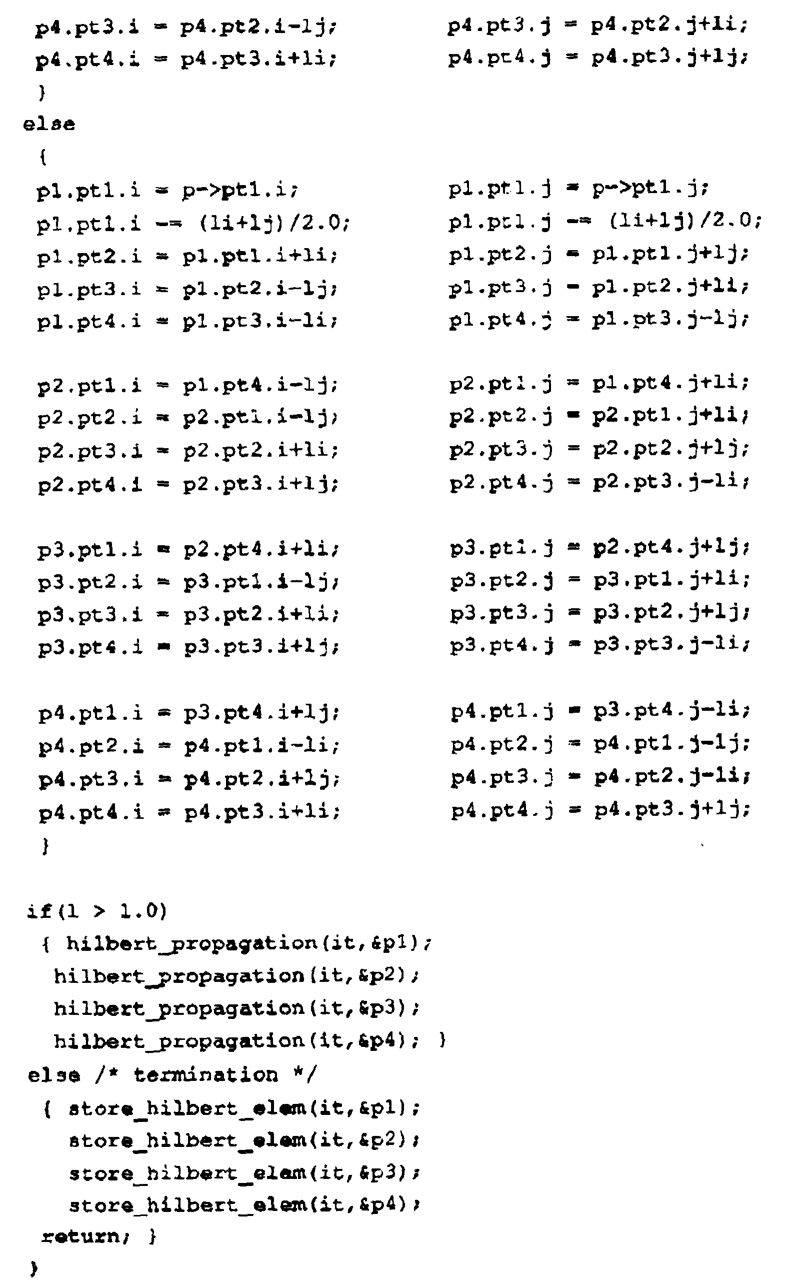

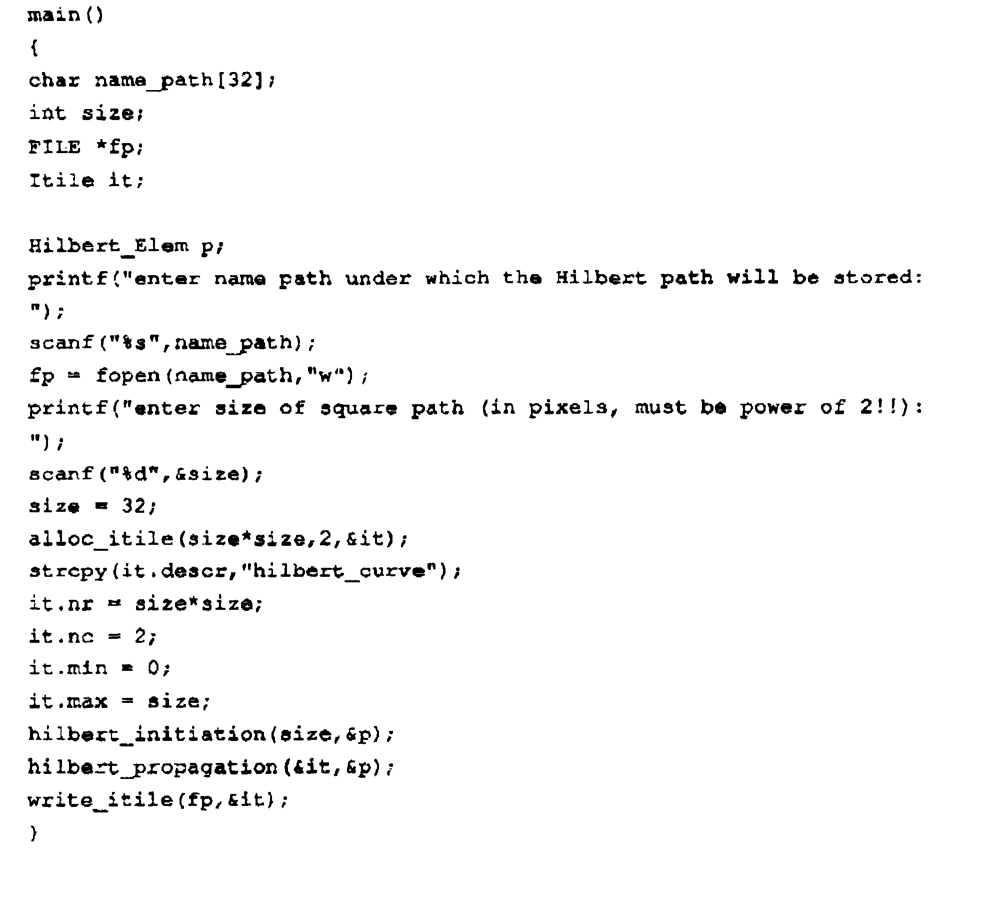

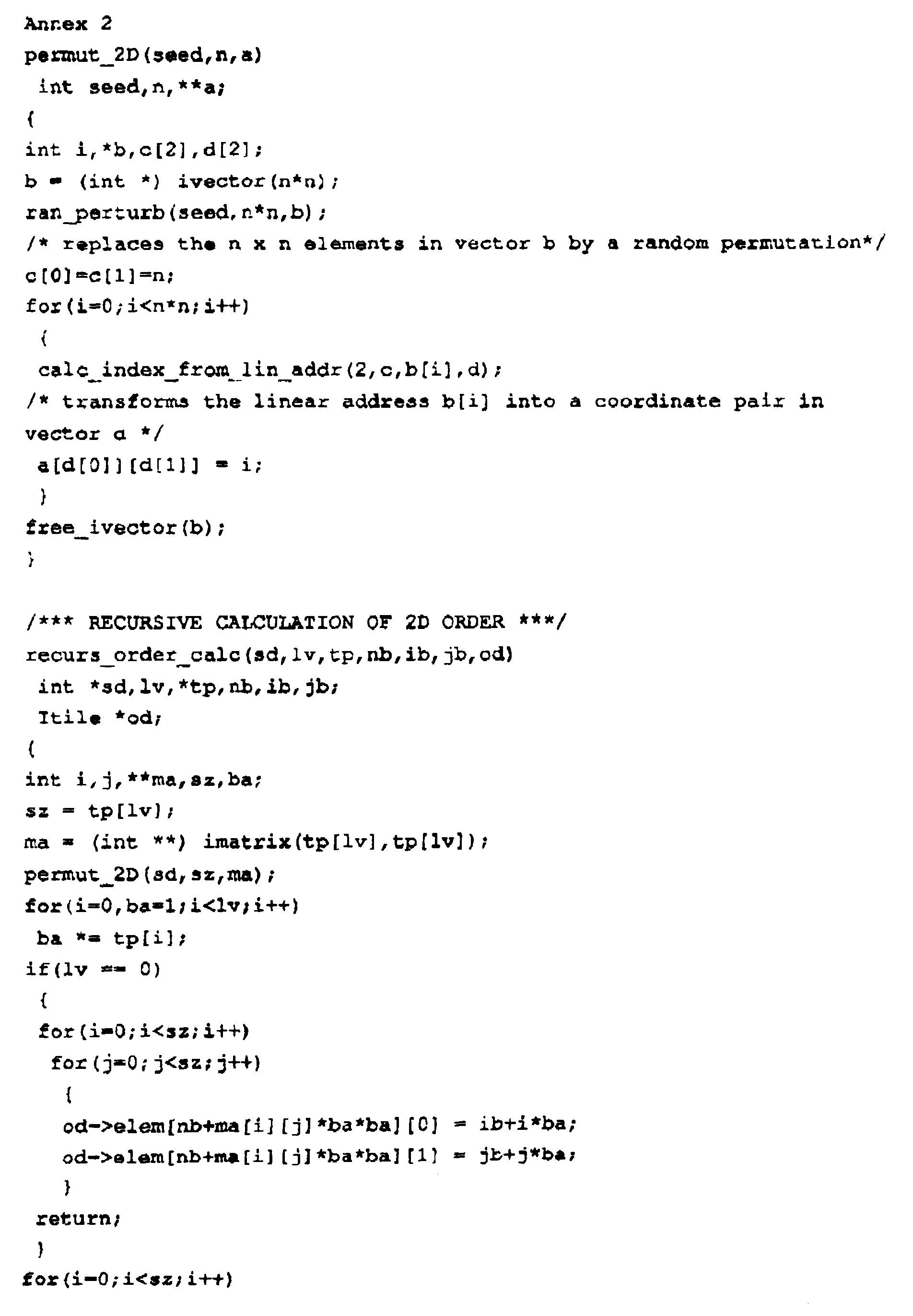

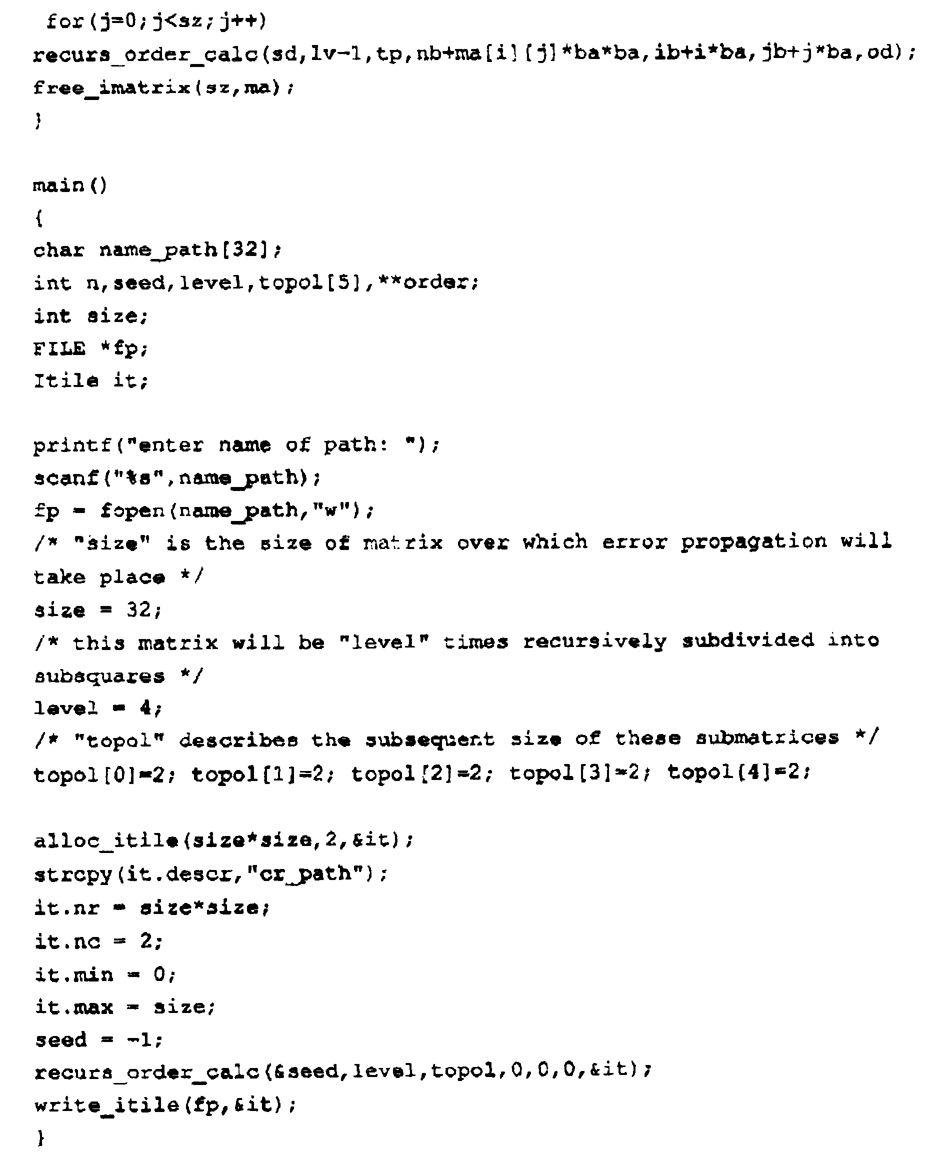

## Claims

1. A method for making a lithographic printing plate from an original containing continuous tones comprising the steps of:
- screening said original to obtain screened data
- scan-wise exposing a lithographic printing plate precursor according to said screened data, said lithographic printing plate precursor having a surface capable of being differentiated in ink accepting and ink repellant areas upon said scan-wise exposure and an optional development step and
- optionally developing a thus obtained scan-wise exposed lithographic printing plate precursor,
characterized in that said screening is a frequency modulation screening.

2. A method according to claim 1 wherein said frequency modulation screening proceeds according to the following steps:
- selecting an unprocessed image pixel according to a space filling deterministic fractal curve or a randomized space filling curve and processing said unprocessed image pixel as follows:
- determining from the tone value of said unprocessed image pixel a reproduction value to be used for recording said image pixel on a recording medium,
- calculating an error value on the basis of the difference between said tone value of said unprocessed image pixel and said reproduction value, said unprocessed image pixel thereby becoming a processed image pixel,
- adding said error value to the tone value of an unprocessed image pixel and replacing said tone value with the resulting sum or alternatively distributing said error value over two or more unprocessed image pixels by replacing the tone value of each of said unprocessed image pixels to which said error value will be distributed by the sum of the tone value of the unprocessed image pixel and part of said error,
- repeating the above steps until all image pixels are processed.

3. A method according to claim 2 wherein said original having continuous tones is subdivided in matrices of unprocessed image pixels and all of said image pixels within a matrix is processed before a subsequent matrix is processed.

4. A method according to any of the above claims wherein said lithographic printing plate precursor contains a photosensitive layer.

5. A method according to claim 1, 2 or 3, wherein said lithographic printing plate precursor contains a heat mode recording layer containing a substance capable of converting light into heat.

6. A method according to any of the above claims wherein lithographic printing plate precursor contains a silver halide emulsion layer and an image receiving layer containing physical development nuclei and wherein subsequent to said scan-wise exposure said lithographic printing plate is developed using an alkaline processing liquid in the presence of developing agent(s) and silver halide solvent(s).

7. A method according to any of the above claims wherein said scan-wise exposure is carried using a laser or LED.

## Patentansprüche

1. Verfahren zur Herstellung einer lithographischen Druckform nach einer Halbtonvorlage, bei dem man:
- die Vorlage rastert, wobei man Rasterdaten erhält
- entsprechend den Rasterdaten eine lithographische Druckplatte scannermäßig belichtet, wobei die Druckplatte eine Oberfläche aufweist, die durch scannermäßige Belichtung und gegebenenfalls einen Entwicklungsschritt in farbannehmende und farbabweisende Bereiche differenziert werden kann, und
- gegebenenfalls die so erhaltene, scannermäßig belichtete lithographische Druckplatte entwickelt,
dadurch gekennzeichnet, daß es sich bei der Rasterung um eine frequenzmodulierte Rasterung handelt.

2. Verfahren nach Anspruch 1, bei dem man die frequenzmodulierte Rasterung nach folgenden Schritten vornimmt:
- Auswahl eines unverarbeiteten Bildpixels gemäß einer raumerfüllenden deterministischen Fraktalkurve oder einer raumerfüllenden Zufallskurve und Verarbeitung des unverarbeiteten Bildpixels wie folgt:
- Bestimmung eines zur Aufzeichnung des Bildpixels auf einem Aufzeichnungsmedium verwendbaren Wiedergabewerts aus dem Tonwert des unverarbeiteten Bildpixels,
- Berechnung eines Fehlerwerts auf der Basis der Differenz zwischen dem Tonwert des unverarbeiteten Bildpixels und dem Wiedergabewert, wodurch aus dem unverarbeiteten Bildpixel ein verarbeitetes Bildpixel wird,
- Addition des Fehlerwerts zum Tonwert eines unverarbeiteten Bildpixels und Ersetzen des Tonwerts durch die sich ergebende Summe oder wahlweise Verteilen des Fehlerwerts auf zwei oder mehr unverarbeitete Bildpixel durch Ersetzen des Tonwerts jedes dieser unverarbeiteten Bildpixel, auf die der Fehlerwert verteilt wird, durch die Summe aus dem Tonwert des unverarbeiteten Bildpixels und einem Teil des Fehlers,
- Wiederholung der obigen Schritte, bis alle Bildpixel verarbeitet sind.

3. Verfahren nach Anspruch 2, bei dem man die Halbtonvorlage in Matrizen unverarbeiteter Bildpixel unterteilt und alle Bildpixel in einer Matrix verarbeitet, bevor man eine nachfolgende Matrix verarbeitet.

4. Verfahren nach einem der vorhergehenden Ansprüche, bei dem die lithographische Druckplatte eine lichtempfindliche Schicht enthält.

5. Verfahren nach Anspruch 1, 2 oder 3, bei dem die lithographische Druckplatte eine Wärmeaufzeichnungsschicht enthält, die eine Substanz enthält, die Licht in Wärme umwandeln kann.

6. Verfahren nach einem der vorhergehenden Ansprüche, bei dem die lithographische Druckplatte eine Silberhalogenidemulsionsschicht und eine Bildempfangsschicht mit physikalischen Entwicklungskeimen enthält und bei dem man die lithographische Druckform nach der scannermäßigen Belichtung in Gegenwart von einem oder mehreren Entwicklern und einem oder mehreren Silberhalogenidlösungsmitteln mit einer alkalischen Verarbeitungsflüssigkeit entwickelt.

7. Verfahren nach einem der vorhergehenden Ansprüche, bei dem man die scannermäßige Belichtung mittels eines Lasers oder einer Leuchtdiode (LED) durchführt.

## Revendications

1. Procédé de fabrication d'une plaque d'impression lithographique à partir d'un original contenant des tons continus, comprenant les étapes qui consistent à:
- tramer ledit original pour obtenir des données tramées,
- exposer selon un balayage un précurseur de plaque d'impression lithographique selon lesdites données tramées, ledit précurseur de plaque d'impression lithographique ayant une surface capable d'être différenciée en zones acceptant l'encre et en zones repoussant l'encre, lors de ladite exposition selon un balayage, et d'une étape de développement facultative, et
- développer éventuellement un précurseur de plaque d'impression lithographique, exposé selon un balayage, ainsi obtenu;
caractérisé en ce que ledit tramage est un tramage à modulation de fréquence.

2. Procédé selon la revendication 1, dans lequel ledit tramage à modulation de fréquence se déroule selon les étapes suivantes, qui consistent à:
- sélectionner un pixel d'image non traité selon une courbe fractale déterministe de remplissage de l'espace ou une courbe randomisée de remplissage de l'espace, et traiter ledit pixel d'image non traité de la manière suivante:
- déterminer, d'après la valeur de ton dudit pixel d'image non traité, une valeur de reproduction à utiliser pour enregistrer ledit pixel d'image sur un support d'enregistrement,
- calculer une valeur d'erreur sur la base de la différence entre ladite valeur de ton dudit pixel d'image non traité et ladite valeur de reproduction, ledit pixel d'image non traité devenant ainsi un pixel d'image traité,
- ajouter ladite valeur d'erreur à la valeur de ton d'un pixel d'image non traité et remplacer ladite valeur de ton par la somme résultante, ou bien distribuer ladite valeur d'erreur sur deux ou plus de deux pixels d'image non traités en remplaçant la valeur de ton de chacun desdits pixels d'image non traités sur lesquels ladite valeur d'erreur sera distribuée par la somme de la valeur de ton du pixel d'image non traité et d'une partie de ladite erreur,
- répéter les étapes ci-dessus, jusqu'à ce que tous les pixels d'image aient été traités.

3. Procédé selon la revendication 2, dans lequel ledit original à tons continus est subdivisé en matrices de pixels d'image non traités, et tous lesdits pixels d'image au sein d'une matrice sont traités avant que la matrice suivante ne soit traitée.

4. Procédé selon l'une quelconque des revendications précédentes, dans lequel ledit précurseur de plaque d'impression lithographique contient une couche photosensible.

5. Procédé selon la revendication 1, 2 ou 3, dans lequel ledit précurseur de plaque d'impression lithographique contient une couche d'enregistrement en mode thermique contenant une substance capable de convertir la lumière en chaleur.

6. Procédé selon l'une quelconque des revendications précédentes, dans lequel le précurseur de plaque d'impression lithographique contient une couche d'émulsion d'halogénure d'argent et une couche réceptrice d'image contenant des germes de développement physique, et dans lequel, après ladite exposition selon un balayage, ladite plaque d'impression lithographique est développée avec un liquide de traitement alcalin, en présence d'un ou de plusieurs agents développateurs et d'un ou de plusieurs solvants de l'halogénure d'argent.

7. Procédé selon l'une quelconque des revendications précédentes, dans lequel ladite exposition selon un balayage est réalisée avec un laser ou une diode électroluminescente.
